# EUROPÄISCHE PATENTSCHRIFT

(11) **EP 3 949 103 B1**
(45) Veröffentlichungstag und Bekanntmachung des Hinweises auf die Patenterteilung: **19.08.2026**
(21) Anmeldenummer: 20714996.4
(22) Anmeldetag: 25.03.2020
(51) Int. Cl.: H02M 7/00, H05K 9/00

(54) **ELEKTRONISCHE SCHALTUNGSEINHEIT**
ELECTRONIC CIRCUIT MODULE
UNITÉ DE CIRCUIT ÉLECTRONIQUE

(30) Priorität: 05.04.2019 DE 102019204889
(43) Veröffentlichungstag der Anmeldung: 09.02.2022
(73) Patentinhaber: Robert Bosch GmbH, 70442 Stuttgart (DE)
(72) Erfinder: KIENLE, Wolfram, 71106 Magstadt (DE); FLAMM, Gunter, 72820 Sonnenbuehl (DE); SCHUETZ, Reiner, 71254 Ditzingen (DE)
(86) Internationale Anmeldenummer: PCT/EP2020/058282
(87) Internationale Veröffentlichungsnummer: WO 2020/200946

(56) Entgegenhaltungen:
- US-A1- 2013 093 046
- US-A1- 2017 164 509

## Beschreibung

### Stand der Technik

Die Erfindung betrifft eine elektronische Schaltungseinheit, insbesondere eine Schaltungseinheit, die als Inverter für eine elektrische Maschine oder als Konverter dient, mit den Merkmalen des Oberbegriffs des unabhängigen Anspruchs 1.

In Hybridfahrzeugen oder Elektrofahrzeugen werden Inverterstrukturen und Konverterstrukturen mit Kommutierungskreisen aus Zwischenkreiskondensatoren und Halbbrücken, die beispielsweise in Leistungsmodulen ausgebildet sind, eingesetzt. Beispielsweise werden zum Betreiben einer elektrischen Maschine Inverter verwendet, die Phasenströme für die elektrische Maschine bereitstellen. Die Inverter und Konverter umfassen beispielsweise Leistungsmodule und wenigstens einen Zwischenkreiskondensator, der kurzzeitig die elektrische Energie zur Verfügung stellt. Die Leistungsmodule können beispielsweise ein Trägersubstrat mit Leiterbahnen umfassen, auf dem beispielsweise Leistungshalbleiter angeordnet sind, die zusammen mit dem Trägersubstrat eine Elektronikbaugruppe bilden. Es ist bekannt, dass Anschlusskontakte des Zwischenkreiskondensators mit den Leistungsmodulen elektrisch leitend verbunden werden. Dazu werden aus dem Leistungsmodul herausgeführte Kontaktelemente, die die Elektronikbaugruppe elektrisch kontaktieren, mit den Anschlusskontakten des Zwischenkreiskondensators verbunden. Die Elektronikbaugruppe kann von einer elektrisch isolierenden Masse umgossen sein, aus der die Kontaktelemente, die die Elektronikbaugruppe elektrisch kontaktieren, herausgeführt sind und außerhalb der elektrisch isolierenden Masse mit den Anschlusselementen verbunden sind.

Die US 2007 0109715 A1 zeigt einen solchen Zwischenkreiskondensator, der mit Leistungsmodulen elektrisch leitend verbunden ist. Die Elektronikbaugruppen der Leistungsmodule sind dabei in Rahmen angeordnet und Kontaktelemente, die die Elektronikbaugruppe elektrisch kontaktieren, sind zur weiteren Kontaktierung aus dem Rahmen herausgeführt und dann mit den Anschlusskontakten des Zwischenkreiskondensators verschraubt und dadurch elektrisch leitend kontaktiert.

Weiterer Stand der Technik ist in US 2013/093046 A1 offenbart.

### Offenbarung der Erfindung

Erfindungsgemäß wird eine elektronische Schaltungseinheit, insbesondere eine Schaltungseinheit, die als Inverter für eine elektrische Maschine oder als Konverter dient, vorgeschlagen. Die elektronische Schaltungseinheit umfasst wenigstens eine Elektronikeinheit, insbesondere eine Leistungselektronikeinheit, wobei die Elektronikeinheit wenigstens ein Trägersubstrat und wenigstens ein auf dem Trägersubstrat angeordnetes elektrisches und/oder elektronisches Bauelement umfasst, wobei an dem Trägersubstrat auf einer Substratoberseite des Trägersubstrats wenigstens eine erste Anschlussstelle und wenigstens zwei zweite Anschlussstellen ausgebildet sind, wobei die erste Anschlussstelle zwischen den zwei zweiten Anschlussstellen angeordnet ist, wobei die elektronische Schaltungseinheit weiterhin wenigstens ein elektrisches oder elektronisches Bauteil mit wenigstens einer ersten Stromschiene zur elektrischen Kontaktierung des elektronischen Bauteils und wenigstens einer zweiten Stromschiene zur elektrischen Kontaktierung des elektronischen Bauteils umfasst. Erfindungsgemäß verbindet ein elektrisch leitfähiges Brückenelement die zwei zweiten Anschlussstellen elektrisch leitend miteinander, wobei das Brückenelement brückenartig über die erste Anschlussstelle geführt ist und durch einen Zwischenraum von dieser beabstandet und elektrisch isoliert ist, wobei die erste Anschlussstelle durch erste Verbindungselemente mit der ersten Stromschiene elektrisch leitend verbunden ist und die zweiten Anschlussstellen durch zweite Verbindungselemente mit der zweiten Stromschiene elektrisch leitend verbunden sind.

### Vorteile der Erfindung

Gegenüber dem Stand der Technik weist die elektronische Schaltungseinheit mit den Merkmalen des unabhängigen Anspruchs den Vorteil auf, dass bei der elektronischen Schaltungseinheit die Induktivität in dem Bereich, in dem die Stromschienen des elektronischen Bauteils mit der Elektronikeinheit durch die Verbindungselemente elektrisch leitend verbunden ist, stark reduziert ist. Dies wird dadurch erreicht, dass die zwei zweiten Anschlussstellen auf dem Trägersubstrat durch das Brückenelement elektrisch leitend verbunden sind. Obwohl das Trägersubstrat, beispielsweise ein DBC-Substrat (direct bonded cooper) einlagig strukturiert ist und zwischen den beiden zweiten Anschlussstellen die erste Anschlussstelle auf dem Trägersubstrat angeordnet ist, können durch die Überbrückung der ersten Anschlussstelle die beiden zweiten Anschlussstellen trotzdem auch in dem Bereich zwischen den beiden zweiten Anschlussstellen von den zweiten Verbindungselementen elektrisch leitend kontaktiert werden. So können im Vergleich zum Stand der Technik mehr T+/T- Kontaktpaare an Verbindungselementen den elektrisch leitenden Kontakt zwischen den Stromschienen und den Anschlussstellen des Trägersubstrates herstellen. Ein T+/T- Kontaktpaar bezeichnet dabei ein Paar aus je einem ersten Verbindungselement und einem zweiten Verbindungselement. Das erste Verbindungselement und das zweite Verbindungselement führen Strom in entgegengesetzter Richtung. Durch das Brückenelement können eine Vielzahl an Paaren aus je einem ersten Verbindungselement und je einem zweiten Verbindungselement zur Verbindung der Stromschienen mit den Anschlusstellen ausgebildet sein. So kann die Induktivität in der elektronischen Schaltungseinheit reduziert werden und somit ein schnelleres Schalten der Halbleiterschalter in der elektronischen Schaltungseinheit erreicht werden.

Weitere vorteilhafte Ausgestaltungen und Weiterbildungen der Erfindungen werden durch die in den Unteransprüchen angegebenen Merkmale ermöglicht.

Gemäß einem vorteilhaften Ausführungsbeispiel ist vorgesehen, dass die ersten Verbindungselemente als Bändchenbonds und/oder Drahtbonds ausgebildet sind und/oder die zweiten Verbindungselemente als Bändchenbonds und/ oder als Drahtbonds ausgebildet sind. Durch Bändchenbonds oder Drahtbonds als Verbindungselemente können die Stromschienen mit den Anschlussstellen des Substrats vorteilhaft gut und einfach verbunden werden und es können eine Vielzahl an Paaren aus Verbindungselementen zur Verbindung verwendet werden. Durch die hohe Anzahl an Paaren aus Verbindungselementen wird die Induktivität im Bereich der Verbindung zwischen den Stromschienen und den Anschlussstellen des Substrats vorteilhaft verringert.

Gemäß einem vorteilhaften Ausführungsbeispiel ist vorgesehen, dass die die ersten Verbindungselemente und die zweiten Verbindungselemente alternierend angeordnet sind. Durch diese abwechselnde Anordnung von ersten und zweiten Verbindungselementen sind erste Verbindungselemente beispielsweise zwischen zwei zweiten und/oder umgekehrt zweite Verbindungselemente zwischen zwei ersten Verbindungselementen angeordnet. Somit können zusätzlich zur Reduktion der Induktivität durch die einzelnen Paare aus Verbindungselementen auch die Paare untereinander wechselwirken und die Induktivität der Verbindung zwischen den Stromschienen und den Anschlussstellen des Substrats weiter reduziert werden.

Gemäß einem vorteilhaften Ausführungsbeispiel ist vorgesehen, dass die ersten Verbindungselemente und die zweiten Verbindungselemente parallel zueinander angeordnet sind. Durch eine parallele Anordnung verlaufen die Strompfade in den Verbindungselementen parallel zueinander und in den ersten Verbindungselementen und den zweiten Verbindungselementen in entgegengesetzter Richtung parallel zueinander. Dadurch wird die Induktivität der Verbindung zwischen den Stromschienen und den Anschlussstellen des Substrats durch die Verbindungselemente weiter reduziert.

Gemäß einem vorteilhaften Ausführungsbeispiel ist vorgesehen, dass sich die erste Anschlussstelle flächig in einer Erstreckungsrichtung auf dem Trägersubstrat zwischen den zwei zweiten Anschlussstellen erstreckt. Dabei erstreckt sich die erste Anschlussstelle beispielsweise parallel zu dem Brückenelement. So können die Verbindungselemente in Paaren und/oder alternierend über die gesamte Erstreckung der ersten Anschlussstelle und des Brückenelements elektrisch leitend kontaktiert werden.

Gemäß einem vorteilhaften Ausführungsbeispiel ist vorgesehen, dass die Punkte, an denen die ersten Verbindungselemente mit der ersten Anschlussstelle elektrisch leitend kontaktiert sind, nebeneinander entlang der Erstreckungsrichtung angeordnet sind.

Gemäß einem vorteilhaften Ausführungsbeispiel ist vorgesehen, dass die Punkte, an denen die zweiten Verbindungselemente mit dem Brückenelement elektrisch leitend verbunden sind, entlang einer Erstreckungsrichtung des Brückenelements nebeneinander angeordnet sind.

Gemäß einem vorteilhaften Ausführungsbeispiel ist vorgesehen, dass die ersten Verbindungselemente entlang der ersten Stromschiene elektrisch leitend mit der ersten Stromschiene kontaktiert sind und/oder die zweiten Verbindungselemente entlang der zweiten Stromschiene elektrisch leitend mit der zweiten Stromschiene kontaktiert sind.

Gemäß einem vorteilhaften Ausführungsbeispiel ist vorgesehen, dass das Brückenelement als Metallstreifen ausgebildet ist. Das Brennelement weist so eine gute elektrische Leitfähigkeit auf und kann vorteilhaft gut geformt, verarbeitet und kontaktiert werden.

Gemäß einem vorteilhaften Ausführungsbeispiel ist vorgesehen, dass in dem Zwischenraum zwischen dem Brückenelement und der ersten Anschlussstelle ein elektrisch isolierendes Abstandselement angeordnet ist. Das elektrisch isolierende Abstandselement trennt das elektrisch leitende Brückenelement von der ersten Anschlussstelle und isoliert dieses von der ersten Anschlussstelle. Gleichzeitig kann das Abstandselement einen thermischen Kontakt von dem Brückenelement zu dem Trägersubstrat herstellen und Wärme kann von dem Brückenelement über das Trägersubstrat beispielsweise an einen Kühlkörper abgeleitet werden.

### Kurze Beschreibung der Zeichnungen

Ein Ausführungsbeispiel der Erfindung ist in der Zeichnung dargestellt und wird in der nachfolgenden Beschreibung näher erläutert. Es zeigen
Fig. 1 eine Darstellung einer elektronischen Schaltungseinheit aus dem Stand der Technik,
Fig. 2 eine Draufsicht auf eine elektronische Schaltungseinheit aus dem Stand der Technik,
Fig. 3 zeigt eine Darstellung eines Ausführungsbeispiels der erfindungsgemäßen elektronischen Schaltungseinheit.

### Ausführungsformen der Erfindung

Die erfindungsgemäße elektronische Schaltungseinheit kann vielfältige Anwendung finden, beispielsweise als Inverter oder Konverter in der Kraftfahrzeugtechnik. Beispielsweise kann die elektronische Schaltungseinheit als auch als Wechselrichter bezeichneter Inverter für den Betrieb einer elektrischen Maschine beispielsweise von Hybrid- oder Elektrofahrzeugen eingesetzt werden.

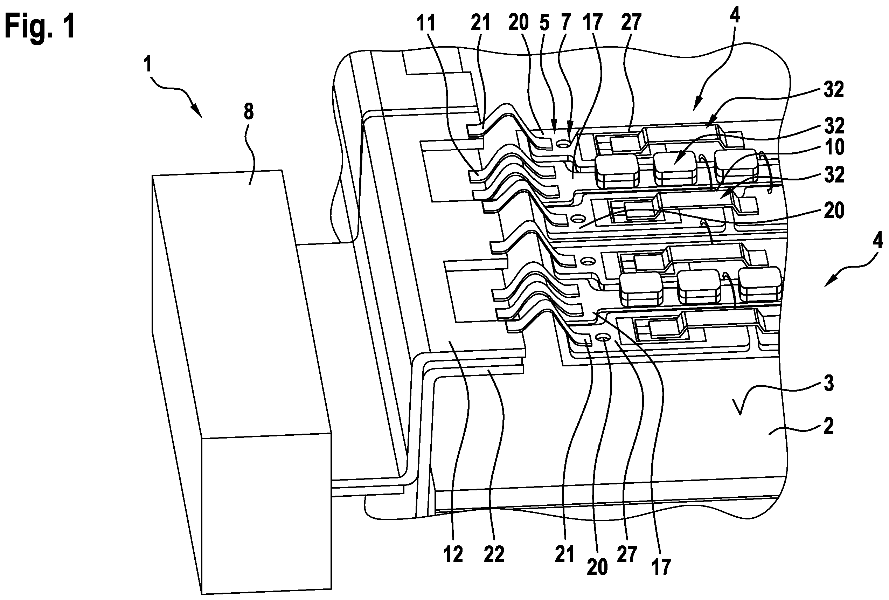

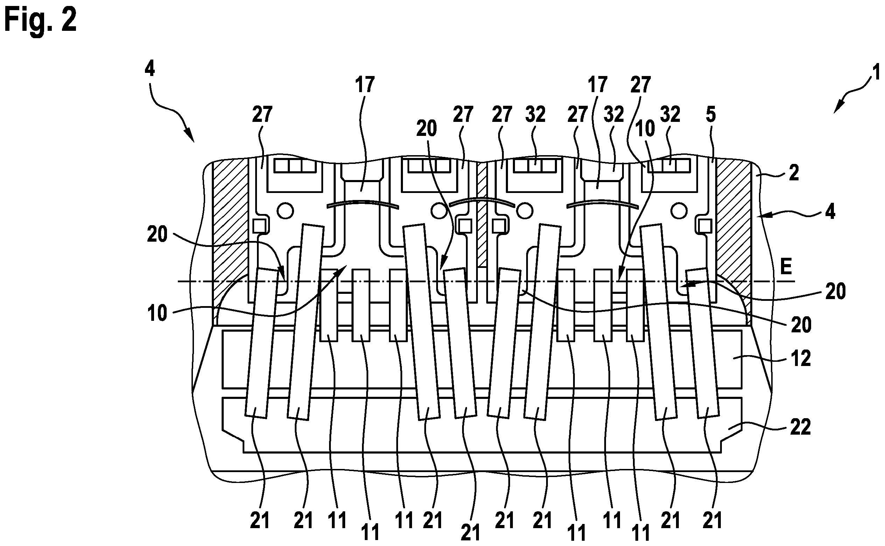

Figur 1 und Figur 2 zeigen Ausführungsbeispiele von elektronischen Schaltungseinheiten 1 aus dem Stand der Technik. Die Schaltungseinheit 1 umfasst eine Elektronikeinheit 4, insbesondere eine Leistungselektronikeinheit, wobei die Elektronikeinheit 4 ein Trägersubstrat 5 und auf dem Trägersubstrat 5 angeordnete elektrische und/oder elektronische Bauelemente 32 umfasst. Das Trägersubstrat 5 kann mehrere Schichten aus elektrisch leitfähigen Materialien wie Metallen und/oder diaelektrischen Materialien umfassen. Bei dem Trägersubstrat 5 handelt es sich beispielsweise um einen Schaltungsträger, in diesem Ausführungsbeispiel um ein DBC-Substrat (Direct Bonded Copper). Das Trägersubstrat 5 kann aber beispielsweise auch ein AMB-Substrat (Active Metal Brazed), ein IMS (Insulated Metal Substrate), eine Leiterplatte (PCB, Printed Circuit Board) oder ein anderes für Leistungsmodule geeignetes Substrat sein. Auf einer Substratoberseite 7 des Trägersubstrats 5 können verschiedene elektrische und/oder elektronische Bauelemente 32 wie beispielsweise Leistungshalbleiter wie beispielsweise Feldeffekttransistoren wie MIS-FETs (Metal Insulated Semiconductor Field Effect Transistor), IGBTs (insulated-gate bipolar transistor), Leistungs-MOSFETs (metal oxide semiconductor field-effect transistor) und/oder Dioden, beispielsweise Gleichrichterdioden, angeordnet sein. Es kann sich beispielsweise um gehäuselose Leistungshalbleiter (Bare-Die) handeln. Weiterhin können auch passive Bauelemente wie beispielsweise Widerstände oder Kondensatoren als elektrische und/oder elektronische Bauelemente 32 auf dem Trägersubstrat 5 angeordnet sein.

Das Trägersubstrat 5 kann weiterhin Leiterbahnen 17,27 umfassen. Die elektrischen und/oder elektronischen Bauelemente 32 können untereinander oder mit außerhalb der Elektronikeinheit 4 angeordneten und in den Figuren nicht dargestellten weiteren elektrischen und/oder elektronischen Elementen beispielsweise über die Leiterbahnen 17,27 des Trägersubstrats 5, über Bonddrähte oder andere geeignete elektrisch leitende Kontaktelemente beispielsweise durch Löten oder Sintern elektrisch leitend verbunden sein. Die Leiterbahnen 17,27 können wie in diesem Ausführungsbeispiel als Leiterflächen ausgebildet sein. Auf der Substratoberseite 7 des Trägersubstrats 5 ist wenigstens eine erste Anschlussstelle 10 ausgebildet, an der eine erste Leiterbahn 17 elektrisch kontaktiert werden kann. Weiterhin sind auf der Substratoberseite 7 des Trägersubstrats 5 wenigstens zwei zweite Anschlussstellen 20 ausgebildet, an der zweite Leiterbahnen 27 elektrisch leitend kontaktiert werden können. An den Anschlussstellen kann die Elektronikeinheit 4 mit außerhalb der Elektronikeinheit 4 angeordneten Elementen elektrisch leitend verbunden werden. Eine erste Anschlussstelle 10 hat dabei beispielsweise eine der zweiten Anschlussstelle 20 entgegengesetzter Polarität, die mit T-bezeichnet wird, wobei die Polarität der zweiten Anschlussstelle 20 mit T+ bezeichnet wird.

Wie in den Figuren dargestellt umfasst eine Elektronikeinheit 4 auf dem Trägersubstrat eine erste Anschlussstelle 10 und zwei zweite Anschlussstellen 20. Die erste Anschlussstelle 10 ist zumindest teilweise zwischen den zwei Anschlussstellen 20 angeordnet und trennt die zweite Anschlussstellen 20 voneinander. Die zwei Anschlussstellen 20 haben die gleiche Polarität T+. Die zwischen den Anschlussstellen 20 angeordnete Anschlussstelle 10 hat die entgegengesetzte Polarität T-. Die Anschlussstelle 10 bezeichnet beispielsweise einen Bereich der ersten Leiterbahn 17, in dem die Leiterbahn 17 elektrisch leitend kontaktiert werden kann. Die Anschlussstellen 20 bezeichnen beispielsweise Bereiche der zweiten Leiterbahn 27 oder der zweiten Leiterbahnen 27, in denen die Leiterbahn 27 elektrisch leitend kontaktiert werden kann.

In diesem Ausführungsbeispiel ist das Trägersubstrat 5 der Elektronikeinheit 4 auf einer Oberseite 3 eines Kühlkörpers 2 angeordnet und ist beispielsweise auf die Oberseite 3 des Kühlkörpers 2 gelötet. Das Trägersubstrat 5 kann direkt oder unter Zwischenlage einer Wärmeleitschicht auf dem Kühlkörper 2 aufliegen. Der Kühlköper 2 dient zur Ableitung von in der Elektronikeinheit 4 erzeugten Wärme und zeichnet sich durch hohe Wärmeleitfähigkeit aus. Der Kühlkörper 2 ist aus einem Material mit guter Wärmeleitfähigkeit wie beispielsweise Aluminium oder Kupfer gefertigt. In diesem Ausführungsbeispiel ist der Kühlkörper 2 aus Kupfer gefertigt und als Platte ausgebildet. An dem Kühlkörper 2 können beispielsweise auch in den Figuren nicht dargestellte Strukturen zur Verbesserung der Wärmeableitung, wie beispielsweise Rippen, Stifte oder Kanäle, ausgebildet sein. Das Trägersubstrat 5 der Elektronikeinheit 4 kann beispielsweise auch direkt auf der Oberseite 3 des Kühlkörpers 2 aufliegen und beispielsweise durch eine vom Trägersubstrat 5 umfasste elektrisch isolierende Schicht von dem Kühlkörper 2 isoliert sein.

Weiterhin umfasst die elektronische Schaltungseinheit 1, wie in Fig. 1 dargestellt, wenigstens ein elektrisches und/oder elektronisches Bauteil 8, das nicht von der Elektronikeinheit 4 umfasst ist. In dem in der vorliegenden Anmeldung beschriebenen Ausführungsbeispiel handelt es sich bei dem elektrischen und/oder elektronischen Bauteil 8 um einen Kondensator. Es kann sich beispielsweise um einen Leistungskondensator handeln, der beispielsweise als Zwischenkreiskondensator der elektronischen Schaltungseinheit 1 dient. Ein solcher Kondensator kann auch mehrere miteinander elektrisch leitend verbundene Kondensatorelemente, die für sich selbst einzelne Kapazitäten bilden, und beispielsweise auch die zur elektrisch leitenden Verbindung dieser Kondensatorelemente nötigen elektrisch leitenden Verbindungselemente umfassen. Dabei können als Kondensator oder als Kondensatorelemente verschiedene Kondensatortechnologien wie beispielsweise Folienkondensatoren, wie Stack- oder Rundwickel-Kondensatoren, oder andere geeignete Kondensatortechnologien eingesetzt werden.

In dem Ausführungsbeispiel umfasst der Kondensator als elektrisches und/oder elektronisches Bauteil 8, zwei Stromschienen 12, 22. Im Kontext der vorliegenden Anmeldung wird unter einer Stromschiene 12, 22 des elektrischen und/oder elektronischen Bauteils 8 ein von dem elektrischen und oder elektronischen Bauteil 8 ausgehendes oder abragendes elektrisch leitfähiges und einstückiges Bauteil verstanden das zur elektrischen Kontaktierung des elektrischen und/oder elektronischen Bauteils 8 mit außerhalb des elektrischen und/oder elektronischen Bauteils 8 angeordneten elektrischen und/oder elektronischen Elementen vorgesehen ist. So ragen in diesem Ausführungsbeispiel von dem Kondensator als elektrisches und/oder elektronisches Bauteil 8 zwei Stromschienen 12, 22 ab, die zur elektrischen Kontaktierung der zwei Elektroden des Kondensators 8 mit außerhalb des Kondensators 8 angeordneten elektrischen und/oder elektronischen Elementen, wie insbesondere der Elektronikeinheit 4, vorgesehen sind. Die Stromschienen 12, 22 können zumindest teilweise aus einem oder mehreren Metallen, wie etwa Kupfer oder Aluminium gefertigt sein und beispielsweise teilweise isoliert oder auch nicht isoliert sein. Sie können beispielsweise aus Blechen gefertigt sein. In der vorliegenden Anmeldung wird zwischen einer ersten Stromschiene 12 und einen zweiten Stromschiene 22 unterschieden, wobei die erste Stromschiene 12 einen Anschlusskontakt darstellt, der wie in dem Ausführungsbeispiel bei einem Kondensator als elektrisches und/oder elektronisches Bauteil 8 von einer ersten der zwei Elektroden eines Kondensators ausgeht und die zweite Stromschiene 22 einen Anschlusskontakt darstellt, der von einer zweiten der zwei Elektroden des Kondensators ausgeht. In den Figuren sind exemplarisch Stromschienen 12, 22, eine erste Stromschiene 12 eine zweite Stromschiene 22, dargestellt. Es können aber auch mehrere erste und/oder zweite Stromschienen 12, 22 ausgebildet sein, die beispielsweise auch mit an weiteren in den Figuren nicht dargestellten Elektronikeinheiten 4 ausgebildeten weiteren Anschlussstellen elektrisch leitend verbunden sein können. Außerdem kann das elektrische und/oder elektronische Bauteil 8 über andere in den Figuren nicht dargestellte elektrische Kontakte beispielsweise auch mit anderen in den Figuren nicht dargestellten Elementen wie beispielsweise weiteren elektrischen und/oder elektronischen Bauteilen 8 elektrisch leitend verbunden sein.

Wie in Fig.1 dargestellt ist in der elektronischen Schaltungseinheit 1 die erste Stromschiene 12 flächig ausgebildet und die zweite Stromschiene 22 flächig ausgebildet. Unter einer Stromschiene 12,22 wird im Kontext der vorliegenden Anmeldung ein elektrisch leitender flächiger Leiter, beispielsweise eine elektrisch leitende Leiste oder ein elektrisch leitender Streifen, verstanden. Eine Stromschiene 12, 22 kann somit beispielsweise eine Busbar sein. Die Stromschienen 12,22 können beispielsweise gebogen oder gekrümmt sein oder auch kurven- oder stufenartig verlaufen. Die Stromschienen 12,22 können sich dabei weitgehend überlappen und beispielsweise auch zumindest teilweise planparallel zueinander geführt sein um eine möglichst niederinduktive Führung des Stroms zu ermöglichen. Die Stromschienen 12,22 können dazu bevorzugt zumindest in Bereichen auch parallel zueinander geführt sein und beispielsweise auch gleich breit sein.

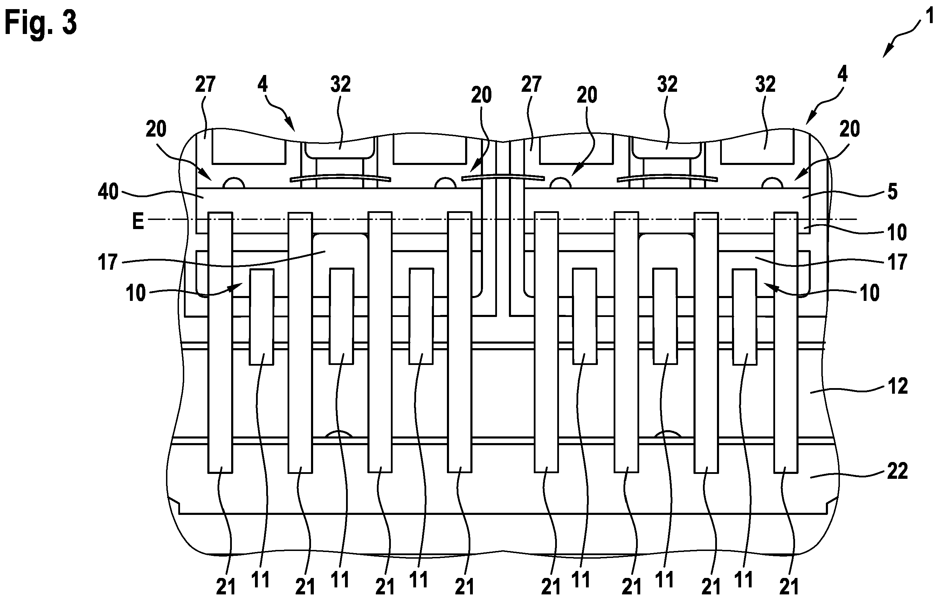

Eine erfindungsgemäße elektronische Schaltungseinheit 1 ist in Figur 3 dargestellt. Darin umfasst die elektronische Schaltungseinheit 1 ein Brückenelement 40. Das Brückenelement 40 ist aus einem elektrisch leitenden Material hergestellt. Das Brückenelement 40 ist beispielsweise als Metallstreifen ausgebildet. Das Brückenelement 40 verbindet die zwei von der ersten Anschlussstelle 10 getrennten zweiten Anschlussstellen 20 elektrisch leitend miteinander. Dazu ist das Brückenelement 40 in Form einer Brücke über die erste Anschlussstelle 10 und/oder die erste Leiterbahn 17 geführt. Das Brückenelement 40 ist dabei von der ersten Anschlussstelle 10 und der ersten Leiterbahn 17 durch einen Zwischenraum beabstandet, der das Brückenelement 40 elektrisch von der ersten Anschlussstelle 10 isoliert. Der Zwischenraum kann leer sein oder es kann ein elektrisch isolierendes Abstandselement in dem Zwischenraum angeordnet sein. Wie in Figur 3 dargestellt verläuft die erste Anschlussstelle 10 auf der Substratoberseite 7 des Trägersubstrats 5 unter dem Brückenelement 40 und zwischen den zwei zweiten Anschlussstellen 20 hindurch und verbreitet sich danach und erstreckt sich flächig in einer Erstreckungsrichtung E auf dem Trägersubstrat 5. Die Erstreckungsrichtung E verläuft dabei beispielsweise parallel zu einer Verbindungslinie zwischen den zwei zweiten Anschlussstellen 20. Das Brückenelement 40 kann beispielsweise durch Löten, Kleben, Sintern und oder Diffusionslöten an den zweiten Anschlusstellen 20 befestigt sein.

Wie in Figur 3 dargestellt, ist die erste Anschlussstelle 10 über eine Vielzahl an ersten Verbindungselementen 11 mit der ersten Stromschiene 12 elektrisch leitend verbunden. Gleichzeitig ist das Brückenelement 40 über eine Vielzahl an zweiten Verbindungselementen 21 mit der zweiten Stromschiene 22 elektrisch leitend verbunden. Somit sind die erste Leiterbahn 17, die erste Anschlussstelle 10, das erste Verbindungselement 11, und die erste Stromschiene 12 elektrisch leitend miteinander verbunden und haben somit das gleiche Potenzial T-. Gleichzeitig sind die zweiten Leiterbahn 27, die zweiten Anschlussstellen 20, das Brückenelement 40, die zweiten Verbindungselemente 21 und die zweite Stromschiene 22 elektrisch leitend miteinander verbunden und somit auf dem gleichen Potenzial T+.

Die Verbindungselemente 11, 12 können beispielsweise als Drahtbonds und/oder als Bändchenbonds ausgebildet sein. In diesem Ausführungsbeispiel sind drei erste Verbindungselemente 11 vorgesehen, die als Bändchenbonds ausgebildet sind, und vier zweite Verbindungselemente 21, die auch als Bändchenbonds ausgebildet sind.

In Figur 3 dargestellt sind die ersten Verbindungselemente 11 und die zweiten Verbindungselemente 21 dabei alternierend angeordnet, d.h. das abwechselnd ein erstes Verbindungselement 11 und ein zweites Verbindungselement 21 zur Verbindung angeordnet sind. So folgen Verbindungselemente 11, 21 mit entgegengesetzten Polaritäten T+, T- aufeinander und die Induktivität der Verbindung zwischen der Elektronikeinheit 4 und dem elektronischen Bauteil 8 wird reduziert.

Die Verbindungselemente 11, 21 sind parallel zueinander angeordnet. So können beispielsweise jeweils ein erstes Verbindungselement 11 und ein zweites Verbindungselement 21 paarweise parallel zueinander ausgerichtet sein. Es können beispielsweise, wie in Figur 3 gezeigt, aber auch alle Verbindungselemente 11, 21 parallel zueinander ausgerichtet sein.

Jedes der ersten Verbindungselemente 11 weist ein erstes Ende auf, an dem es mit der ersten Verbindungsstelle 10 verbunden ist, und weist ein zweites Ende auf, an dem es mit der ersten Busbar 12 verbunden ist. Genauso weist jedes der zweiten Verbindungselemente 21 ein erstes Ende auf, an dem es mit dem Brückenelement 40 verbunden ist, und ein zweites Ende auf, an dem es mit der zweiten Busbar 22 verbunden ist. Die Punkte, an denen die ersten Verbindungselemente 11 an dem ersten Ende mit der ersten Anschlussstelle 10 elektrisch leitend kontaktiert sind, reihen sich nebeneinander an der ersten Verbindungsstelle 10 entlang der Erstreckungsrichtung E. Die Punkte, an denen die ersten Verbindungselemente 11 einem zweiten Ende mit der ersten Stromschiene 12 elektrisch leitend kontaktiert sind, reihen sich nebeneinander entlang Längserstreckung der ersten Stromschiene 12. Die Punkte, an denen die zweiten Verbindungselemente 21 an dem ersten Ende mit dem Brückenelement 40 elektrisch leitend kontaktiert sind, reihen sich nebeneinander an dem Brückenelement 40. Die Punkte, an denen die zweiten Verbindungselemente 21 an dem zweiten Ende der zweiten Stromschiene 22 elektrisch leitend kontaktiert sind, reihen sich nebeneinander entlang der Längserstreckung der zweiten Stromschiene 22.

Selbstverständlich sind auch weitere Ausführungsbeispiele und Mischformen der dargestellten Ausführungsbeispiele möglich.

## Patentansprüche

1. Elektronische Schaltungseinheit (1), insbesondere eine Schaltungseinheit, die als Inverter für eine elektrische Maschine oder als Konverter dient, umfassend wenigstens eine Elektronikeinheit (4), insbesondere eine Leistungselektronikeinheit, wobei die Elektronikeinheit (4) wenigstens ein Trägersubstrat (5) und wenigstens ein auf dem Trägersubstrat (5) angeordnetes elektrisches und/oder elektronisches Bauelement (32) umfasst, wobei an dem Trägersubstrat (5) auf einer Substratoberseite (7) des Trägersubstrats (5) wenigstens eine erste Anschlussstelle (10) und wenigstens zwei zweite Anschlussstellen (20) ausgebildet sind, wobei die erste Anschlussstelle (10) zwischen den zwei zweiten Anschlussstellen (20) angeordnet ist,
wobei die elektronische Schaltungseinheit (1) weiterhin wenigstens ein elektrisches oder elektronisches Bauteil (8) mit wenigstens einer ersten Stromschiene (12) zur elektrischen Kontaktierung des elektronischen Bauteils (8) und wenigstens einer zweiten Stromschiene (22) zur elektrischen Kontaktierung des elektronischen Bauteils (8) umfasst,
wobei ein elektrisch leitfähiges Brückenelement (40) die zwei zweiten Anschlussstellen (20) elektrisch leitend miteinander verbindet, wobei das Brückenelement (40) brückenartig über die erste Anschlussstelle (10) geführt ist und durch einen Zwischenraum von dieser beabstandet und elektrisch isoliert ist,
wobei die erste Anschlussstelle (10) durch erste Verbindungselemente (11) mit der ersten Stromschiene (12) elektrisch leitend verbunden ist und die zweiten Anschlussstellen (20) durch zweite Verbindungselemente (21) mit der zweiten Stromschiene (22) elektrisch leitend verbunden sind.

2. Elektronische Schaltungseinheit nach Anspruch 1, **dadurch gekennzeichnet, dass** die ersten Verbindungselemente (11) als Bändchenbonds und/oder Drahtbonds ausgebildet sind und/oder die zweiten Verbindungselemente (21) als Bändchenbonds und/ oder als Drahtbonds ausgebildet sind.

3. Elektronische Schaltungseinheit nach einem der vorhergehenden Ansprüche, **dadurch gekennzeichnet, dass** die die ersten Verbindungselemente (11) und die zweiten Verbindungselemente (21) alternierend angeordnet sind.

4. Elektronische Schaltungseinheit nach einem der vorhergehenden Ansprüche,
**dadurch gekennzeichnet, dass** die ersten Verbindungselemente (11) und die zweiten Verbindungselemente (21) parallel zueinander angeordnet sind.

5. Elektronische Schaltungseinheit nach einem der vorhergehenden Ansprüche,
**dadurch gekennzeichnet, dass** sich die erste Anschlussstelle (10) flächig in einer Erstreckungsrichtung (E) auf dem Trägersubstrat (5) zwischen den zwei zweiten Anschlussstellen (20) erstreckt.

6. Elektronische Schaltungseinheit nach Anspruch 5, **dadurch gekennzeichnet, dass** die Punkte, an denen die ersten Verbindungselemente (11) mit der ersten Anschlussstelle (11) elektrisch leitend kontaktiert sind, nebeneinander entlang der Erstreckungsrichtung (E) angeordnet sind.

7. Elektronische Schaltungseinheit nach einem der vorhergehenden Ansprüche,
**dadurch gekennzeichnet, dass** die Punkte, an denen die zweiten Verbindungselemente (21) mit dem Brückenelement (40) elektrisch leitend verbunden sind, entlang einer Erstreckungsrichtung des Brückenelements (40) nebeneinander angeordnet sind.

8. Elektronische Schaltungseinheit nach einem der vorhergehenden Ansprüche,
**dadurch gekennzeichnet, dass** die ersten Verbindungselemente (11) entlang der ersten Stromschiene (12) elektrisch leitend mit der ersten Stromschiene (12) kontaktiert sind und/oder die zweiten Verbindungselemente (21) entlang der zweiten Stromschiene (22) elektrisch leitend mit der zweiten Stromschiene (22) kontaktiert sind.

9. Elektronische Schaltungseinheit nach einem der vorhergehenden Ansprüche,
**dadurch gekennzeichnet, dass** das Brückenelement (40) als Metallstreifen ausgebildet ist.

10. Elektronische Schaltungseinheit nach einem der vorhergehenden Ansprüche,
**dadurch gekennzeichnet, dass** in dem Zwischenraum zwischen dem Brückenelement (40) und der ersten Anschlussstelle (10) ein elektrisch isolierendes Abstandselement angeordnet ist.

## Claims

1. Electronic circuit unit (1), in particular a circuit unit which serves as an inverter for an electrical machine or as a converter, comprising at least one electronics unit (4), in particular a power electronics unit, wherein the electronics unit (4) comprises at least one carrier substrate (5) and at least one electrical and/or electronic component (32) arranged on the carrier substrate (5), wherein at least one first connection point (10) and at least two second connection points (20) are formed on the carrier substrate (5) on a substrate top side (7) of the carrier substrate (5), wherein the first connection point (10) is arranged between the two second connection points (20),
wherein the electronic circuit unit (1) further comprises at least one electrical or electronic device (8) with at least one first conductor bar (12) for electrically contacting the electronic device (8) and at least one second conductor bar (22) for electrically contacting the electronic device (8),
wherein an electrically conductive bridge element (40) electrically conductively connects the two second connection points (20) to one another,
wherein the bridge element (40) is guided across the first connection point (10) in the manner of a bridge and is spaced apart and electrically insulated from said first connection point by an intermediate space,
wherein the first connection point (10) is electrically conductively connected to the first conductor bar (12) by first connecting elements (11) and the second connection points (20) are electrically conductively connected to the second conductor bar (22) by second connecting elements (21).

2. Electronic circuit unit according to Claim 1, **characterized in that** the first connecting elements (11) are designed as ribbon bonds and/or as wire bonds and/or the second connecting elements (21) are designed as ribbon bonds and/or as wire bonds.

3. Electronic circuit unit according to either of the preceding claims, **characterized in that** the first connecting elements (11) and the second connecting elements (21) are arranged alternately.

4. Electronic circuit unit according to one of the preceding claims, **characterized in that** the first connecting elements (11) and the second connecting elements (21) are arranged parallel in relation to one another.

5. Electronic circuit unit according to one of the preceding claims, **characterized in that** the first connection point (10) extends in a planar manner in a direction of extent (E) on the carrier substrate (5) between the two second connection points (20).

6. Electronic circuit unit according to Claim 5, **characterized in that** the points at which the first connecting elements (11) are in electrically conductive contact with the first connection point (11) are arranged next to one another along the direction of extent (E).

7. Electronic circuit unit according to one of the preceding claims, **characterized in that** the points at which the second connecting elements (21) are electrically conductively connected to the bridge element (40) are arranged next to one another along a direction of extent of the bridge element (40).

8. Electronic circuit unit according to one of the preceding claims, **characterized in that** the first connecting elements (11) along the first conductor bar (12) are in electrically conductive contact with the first conductor bar (12) and/or the second connecting elements (21) along the second conductor bar (22) are in electrically conductive contact with the second conductor bar (22).

9. Electronic circuit unit according to one of the preceding claims, **characterized in that** the bridge element (40) is designed as a metal strip.

10. Electronic circuit unit according to one of the preceding claims, **characterized in that** an electrically insulating spacer element is arranged in the intermediate space between the bridge element (40) and the first connection point (10).

## Revendications

1. Unité de circuit électronique (1), notamment unité de circuit servant d'onduleur pour une machine électrique ou de convertisseur, comprenant au moins une unité électronique (4), notamment une unité électronique de puissance, l'unité électronique (4) comprenant au moins un substrat de support (5) et au moins un composant électrique et/ou électronique (32) disposé sur le substrat de support (5), au moins un premier point de connexion (10) et au moins deux deuxièmes points de connexion (20) étant réalisés sur le substrat de support (5) sur une face supérieure (7) du substrat de support (5), le premier point de connexion (10) étant disposé entre les deux deuxièmes points de connexion (20),
l'unité de circuit électronique (1) comprenant en outre au moins un composant électrique ou électronique (8) comportant au moins une première barre conductrice (12) pour permettre une mise en contact électrique avec le composant électronique (8) et au moins une deuxième barre conductrice (22) pour permettre une mise en contact électrique avec le composant électronique (8),
un élément de pont (40) électroconducteur reliant électriquement l'un à l'autre les deux deuxièmes points de connexion (20),
l'élément de pont (40) étant guidé à la manière d'un pont au-dessus du premier point de connexion (10) et étant espacé de celui-ci par un espace intermédiaire et isolé électriquement de celui-ci,
le premier point de connexion (10) étant relié électriquement à la première barre conductrice (12) par des premiers éléments de connexion (11) et les deuxièmes points de connexion (20) étant reliés électriquement à la deuxième barre conductrice (22) par des deuxièmes éléments de connexion (21).

2. Unité de circuit électronique selon la revendication 1, **caractérisée en ce que** les premiers éléments de connexion (11) sont réalisés sous forme d'interconnexions par rubans et/ou d'interconnexions par fils et/ou les deuxièmes éléments de connexion (21) sont réalisés sous forme d'interconnexions par rubans et/ou d'interconnexions par fils.

3. Unité de circuit électronique selon l'une quelconque des revendications précédentes, **caractérisée en ce que** les premiers éléments de connexion (11) et les deuxièmes éléments de connexion (21) sont disposés en alternance.

4. Unité de circuit électronique selon l'une quelconque des revendications précédentes, **caractérisée en ce que** les premiers éléments de connexion (11) et les deuxièmes éléments de connexion (21) sont disposés parallèlement les uns aux autres.

5. Unité de circuit électronique selon l'une quelconque des revendications précédentes, **caractérisée en ce que** le premier point de connexion (10) s'étend à plat dans une direction d'extension (E) sur le substrat support (5) entre les deux deuxièmes points de connexion (20).

6. Unité de circuit électronique selon la revendication 5, **caractérisée en ce que** les points auxquels les premiers éléments de connexion (11) sont mis en contact de manière électriquement conductrice avec le premier point de connexion (11) sont disposés les uns à côté des autres le long de la direction d'extension (E).

7. Unité de circuit électronique selon l'une quelconque des revendications précédentes, **caractérisée en ce que** les points auxquels les deuxièmes éléments de connexion (21) sont reliés électriquement à l'élément de pont (40) sont disposés les uns à côté des autres le long d'une direction d'extension de l'élément de pont (40).

8. Unité de circuit électronique selon l'une quelconque des revendications précédentes, **caractérisée en ce que** les premiers éléments de connexion (11) sont mis en contact électroconducteur avec la première barre conductrice (12) le long de la première barre conductrice (12) et/ou les deuxièmes éléments de connexion (21) sont mis en contact électroconducteur avec la deuxième barre conductrice (22) le long de la deuxième barre conductrice (22).

9. Unité de circuit électronique selon l'une quelconque des revendications précédentes, **caractérisée en ce que** l'élément de pont (40) est réalisé sous forme de bande métallique.

10. Unité de circuit électronique selon l'une quelconque des revendications précédentes, **caractérisée en ce qu'**un élément d'écartement électriquement isolant est disposé dans l'espace intermédiaire entre l'élément de pont (40) et le premier point de connexion (10).
